# EUROPÄISCHE PATENTSCHRIFT

(11) **EP 0 416 166 B1**
(45) Veröffentlichungstag und Bekanntmachung des Hinweises auf die Patenterteilung: **17.01.1996**
(21) Anmeldenummer: 89116665.4
(22) Anmeldetag: 08.09.1989
(51) Int. Cl.: H01L 29/737

(54) **Verfahren zur Herstellung eines Heterobipolartransistors mit Separation des Kollektoranschlusses**
Methods of making a heterojunction bipolar transistor having a separate collector contact
Méthodes de fabrication d'un transistor bipolaire à hétérojonction et à contact de collecteur séparé

(43) Veröffentlichungstag der Anmeldung: 13.03.1991
(73) Patentinhaber: SIEMENS AKTIENGESELLSCHAFT, D-80333 München (DE)
(72) Erfinder: Zwicknagl, Peter, Dr., D-7000 Stuttgart 80 (DE); Hoepfner, Joachim, Dipl.-Ing., D-8033 Planegg (DE); Schleicher, Lothar, Dipl.-Phys., D-8000 München 83 (DE)

(56) Entgegenhaltungen:
- EP-A- 0 297 886
- DE-A- 3 512 841
- IEEE ELECTRON DEVICE LETTERS, Band 9, Nr. 11, November 1988, Seiten 598-600, IEEE, New York, US; K. MORIZUKA et al.: "AlGaAs/GaAs HBT's fabricated by a self-alignment technology using polyimide for electrode separation"
- IEEE Electron Device Letters, Bd. EDL-8, Nr. 7, Juli 1987, Seiten 303-305 (Chang et al.)

## Beschreibung

In integrierten Schaltungen mit III-V-Heterobipolartransistoren (HBT) sind planare Transistoren für eine einfache, zuverlässige und strukturgenaue Verdrahtung wünschenswert. Gleichzeitig damit werden Anforderungen an höchste Schaltgeschwindigkeiten gestellt. Dies verlangt vom Entwurf des HBT vor allem eine minimale Basis-Kollektor-Grenzfläche (B-C-Fläche) d. h. eine Minimierung des parasitären B-C-Gebietes. Mit dieser Maßnahme können die mittlerweile wesentlichen Beiträge zur Laufzeit im Transistor, nämlich die Kollektorladezeit und die Emitterladezeit stark reduziert werden.

In nichtselbstjustierten HBT-Prozessen bzw. in solchen Prozessen mit nur selbstjustiertem Basis-Emitter-Komplex entsteht eine zusätzliche parasitäre B-C-Fläche, die durch Länge mal Abstand zwischen Emitter und Kollektor bzw. zwischen Basis und Kollektor gegeben ist. Das Problem, eine minimale B-C-Fläche zu erhalten, bleibt bei diesen Heterobipolartransitoren ungelöst, s. dazu z. B.:
K.C.Wang e. a.: "A 4-Bit Quantizer Implemented with AlGaAs/ GaAs Heterojunktion Bipolar Transistors", GaAs IC-Symposium, Technical Digest 1987, S. 83 - 86, Mau-Chung F. Chang e. a.: "AlGaAs/GaAs Heterojunktion Bipolar Transistors Fabricated Using a Self-Aligned Dual-Lift-Off Process", IEEE Electron Device Letters EDL-8, 303 - 305 (1987), Kouhei Morizuka e. a.:"AlGaAs/GaAs HBT's Fabricated by a Self-Alignment Technology Using Polyimide for Electrode Separation", IEEE Electron Device Letters EDL -9, 598 - 600 (1988), K. Morizuka e. a.: "Transit-Time Reduction in AlGaAs/GaAs HBT's Utilizing Velocity Overshoot in the p-Type Collector Region", IEEE Electron Device Letters 9, 585 - 587 (1988).

Eine andere Näherung ist ein totalselbstjustierter HBT, bei dem Emitter und Basis sowie Basis und Kollektor bzw. Emitter und Kollektor durch isolierende Spacerschichten, die weniger als 1 µm breit sind, voneinander getrennt sind. Die bisher in Veröffentlichungen angegebenen Prozesse enden in einer Doppelmesastruktur, die jeweils Emitter und Basis bzw. Basis und Kollektor zusammenfaßt, mit einer starken Oberflächentopographie. Siehe hierzu die folgenden Veröffentlichungen: S. Adachi e. a.: "Collector-Up HBT's Fabricated by Be⁺ and 0⁺ Ion Implantations", IEEE Device Letters EDL-7, 32 - 34 (1986), Mohammad Madihian e. a.: "IEDM 86, 270 - 273 (1986), Y. Ota e. a.: "AlGaAs/GaAs HBT With GaInAs Cap Layer Fabricated by Multiple-Self-Alignment Process Using One Mask", Electronics Letters 25, 610 - 612 (1989). In der DE 35 12 841 A1 ist ein Heterobipolartransistor mit Planarstruktur und ein Verfahren zu seiner Herstellung beschrieben. Bei diesem Transistor sind übereinander eine Subkollektorschicht, eine Kollektorschicht, eine Basisschicht und ein in dieser Basisschicht ausgebildeter Emitterbereich aufgewachsen. Eine bis zur planarisierten Oberseite dieses Bauelementes geführte Kollektormetallisierung ist auf der Subkollektorschicht aufgebracht und durch einen isolierenden Bereich, der von der Oberseite bis zur Subkollektorschicht reicht, von dem Emitter-Basis-Kollektor-Komplex getrennt.

Aufgabe der vorliegenden Erfindung ist es, ein Herstellungsverfahren für einen verbesserten planaren Heterobipolartransistor mit minimierbarer parasitärer Basis-Kollektor-Kapazität anzugeben.

Diese Aufgabe wird mit den Verfahren mit den Merkmalen des Anspruches 1 bzw. 8 gelöst. Weitere Ausgestaltungen ergeben sich aus den jeweiligen abhängigen Ansprüchen.

Es folgt eine Beschreibung der erfindungsgemäßen Herstellungsverfahren und des entsprechenden Heterobipolartransistors anhand der Figuren 1 bis 16.

Fig. 1 zeigt eine spezielle Ausgestaltung eines durch die erfindungsgemäßen Verfahren hergestellten Heterobipolartransistors im Querschnitt.

Fig. 2 bis 5 zeigen im Querschnitt den jeweiligen Aufbau nach vier Verfahrensschritten des erfindungsgemäßen Herstellungsverfahrens.

Fig. 6 bis 9 zeigen im Querschnitt den jeweiligen Aufbau nach vier verschiedenen Schritten eines alternativen erfindungsgemäßen Herstellungsverfahrens.

Fig. 10 und 11 zeigen im Querschnitt den jeweiligen Aufbau nach zwei nachfolgenden Schritten im erfindungsgemäßen Herstellungsverfahren.

Fig. 12 bis 16 zeigen im Querschnitt den jeweiligen Aufbau nach fünf verschiedenen Schritten in einem alternativen dritten Herstellungsverfahren.

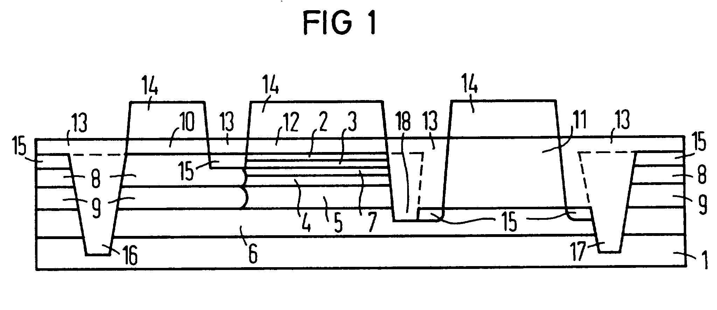

Das Wesentliche bei dem erfindungsgemäßen Heterobipolartransistor ist eine Separation des Kollektoranschlusses von dem Basis-Emitter-Komplex. Diese Separation wird durch einen Kollektortrenngraben zwischen dem Basis-Emitter-Komplex und der Kontaktmetallisierung für den Kollektor bewirkt. Bei dem Ausführungsbeispiel nach Fig. 1 ist ein im übrigen konventioneller Aufbau des Basis-Emitter-Komplexes gezeigt, wobei der Kollektoranschluß durch einen Kollektortrenngraben separiert ist, und eine elektrische Verbindung zu der Kollektorschicht über eine Subkollektorschicht erfolgt.

Bei diesem Aufbau nach Fig. 1 ist auf einem Substrat 1 eine Subkollektorschicht 6 aufgewachsen. Im Bereich des Basis-Emitter-Komplexes folgen darauf nacheinander eine Kollektorschicht 5, eine Basisschicht 4, eine Pufferschicht 7, eine Emitterschicht 3 und eine Deckschicht 2. Diese Schichtfolge kann durch eine andere in der Literatur beschriebene ersetzt sein. Es ist auch möglich, die Anordnung von Basis und Emitter zu vertauschen. Im Bereich der Basis sind die Basisschicht 4 und die darauf aufgewachsenen weiteren Schichten mit einer ersten Implantation versehen. In dem darunter befindlichen Bereich der Kollektorschicht 5 ist entsprechend eine zweite Implantation 9 vorgenommen. Die Basis ist mit einer Basis-Metallisierung 10 und der Emitter mit einer Emitter-Metallisierung 12 versehen. Die Kollektor-Metallisierung 11 ist unmittelbar auf der Subkollektorschicht 6 außerhalb des Basis-Emitter-Komplexes aufgebracht. Diese Kollektor-Metallisierung 11 ist durch einen Kollektortrenngraben 18, der mit einer Passivierung 13 aus isolierendem Material aufgefüllt ist, von dem Basis-Emitter-Komplex elektrisch isoliert. Eine elektrisch leitende Verbindung liegt nur in der Subkollektorschicht 6 vor.

Nach außen ist dieser Heterobipolartransistor z. B. gegen weitere auf dem Substrat befindliche Funktionselemente durch einen ersten Isolationsgraben 16 und einen zweiten Isolationsgraben 17, die ebenfalls mit der Passivierung 13 elektrisch isolierend aufgefüllt sind, elektrisch isoliert. Was in Fig. 1 als erster und zweiter Isolationsgraben 16, 17 eingezeichnet ist, kann auch die jeweilige Querschnittsfläche eines einzigen, um den Transistor herumlaufenden Isolationsgrabens sein. Die nicht mit Metallisierungen versehenen Anteile der Oberfläche des Halblleitermateriales sind jeweils mit Isolationsimplantierung 15 versehen, und die gesamte Oberfläche zwischen den Metallisierungen ist von der Passivierung 13 bedeckt. Auf der Basis-Metallisierung 10, der Emitter-Metallisierung 12 und der Kollektor-Metallisierung 11 ist jeweils eine Verbindungsmetallisierung 14, über die die elektrische Vernetzung der Anschlüsse erfolgt, aufgebracht.

Die epitaktisch aufgewachsenen Schichten aus III-V-Material können z. B. die Materialsysteme AlGaAs/GaAs, InGaAs/InP, InGaAs/InAlAs sein. Bei diesem erfindungsgemäßen Aufbau ist die parasitäre Basis-Kollektor-Fläche minimal, weil das Interface zwischen dem inneren HBT, d. h. dem Basis-Emitter-Komplex und dem Kollektoranschluß mittels des planar aufgefüllten Kollektortrenngrabens 18 durch die Subkollektorschicht 6 festgelegt wird.

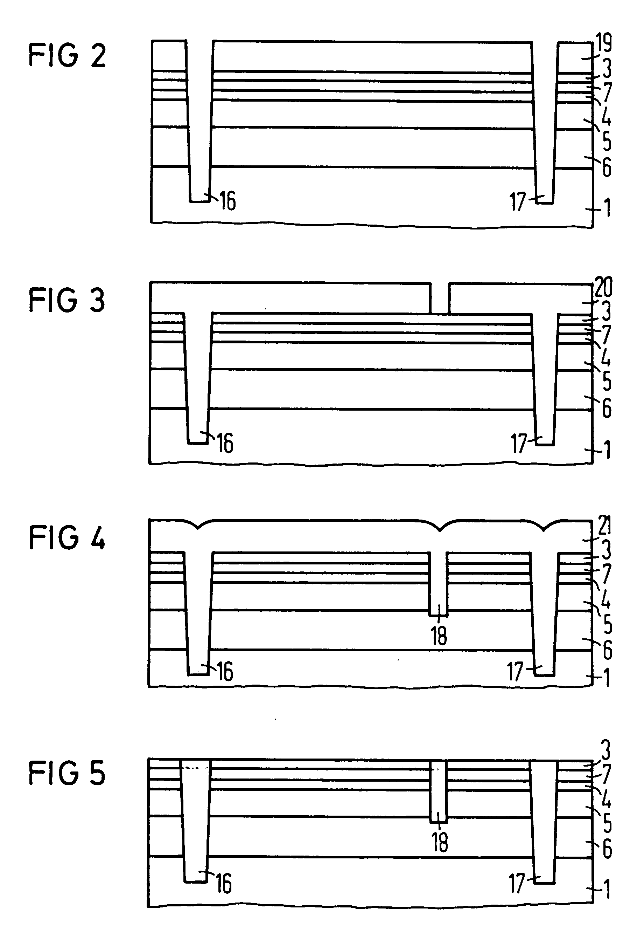

Dieser erfindungsgemäße Heterobipolartransistor wird z. B. wie folgt hergestellt: Auf ein Substrat 1 werden die Subkollektorschicht 6, die Kollektorschicht 5 und die für den Basis-Emitter-Komplex erforderliche Schichtfolge (z. B. Basisschicht 4, Pufferschicht 7 und Emitterschicht 3) aufgewachsen. Gegebenenfalls werden Isolationsgräben 16, 17 mittels Maskentechnik hergestellt. Fig. 2 zeigt den Aufbau im Querschnitt mit einer Lackmaske 19, mit deren Hilfe ein erster Isolationsgraben 16 und ein zweiter Isolationsgraben 17 ausgeätzt wurden. Entsprechend Fig. 3 wird dann eine erste Maske 20 aus z. B. Photolack mit einer Öffnung im Bereich des herzustellenden Kollektortrenngrabens aufgebracht. Der Kollektortrenngraben wird mittels eines für III-V-Halbleitermaterial tauglichen RIE- (reactive ion etching) oder ECR-RIE-Prozesses geätzt. Danach wird die erste Maske 20 entfernt und der Kollektortrenngraben 18 sowie gegebenenfalls die Isolationsgräben 16, 17 mit einer Isolationsschicht gefüllt. Diese Isolationsschicht 21 kann z. B. Photonitrid Si₃N₄ oder SiO₂ sein. Die Oberfläche wird anschließend planarisiert, was z. B. mittels eines (damagearmen) für die Isolationsschicht 21 tauglichen, gegen III-V-Halbleitermaterial selektiven Ätzprozesses geschehen kann. Dabei wird z. B. SF₆ für eine Isolationsschicht 21 aus Si₃N₄ bei ECR-RIE eingesetzt. Wie Fig. 5 zeigt, wird dabei die Oberfläche des Halbleitermaterials in vorliegendem Beispiel die Emitterschicht 3, freigelegt. Die Tiefe des Kollektortrenngrabens 18 wird so gewählt, daß der Boden dieses Kollektortrenngrabens 18 entweder innerhalb der Kollektorschicht 5, d. h. in jedem Fall unterhalb der darauf aufgewachsenen nächsten Halbleiterschicht (in vorliegendem Beispiel die Basisschicht 4), oder in einem oberen Schichtanteil der Subkollektorschicht 6 liegt.

Die auf der Seite des Emitters bzw. der Basis liegende Wand des Kollektortrenngrabens 18 bildet die Grenze des aktiven Transistorbereiches. Die Toleranz, die für die Tiefe des Kollektortrenngrabens 18 eingehalten werden muß, entspricht in etwa der Dicke der Kollektorschicht 5.

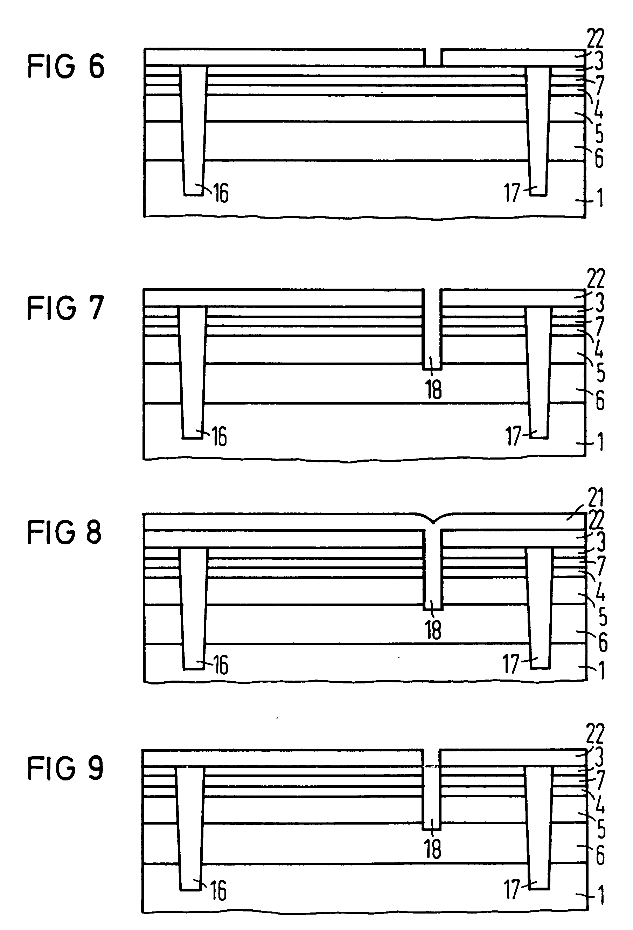

Alternativ zu diesen Verfahrensschritten kann auch eine erste Maske 22 aus Metall verwendet werden. In Fig. 6 ist ein Aufbau im Querschnitt dargestellt, bei dem nach dem Aufwachsen der Schichten aus Halbleitermaterial und dem Ätzen von Isolationsgräben 16, 17 diese Isolationsgräben 16, 17 mit isolierendem Material aufgefüllt wurden und anschließend eine erste Maske 22 aus Metall mit einer Öffnung im Bereich des herzustellenden Kollektortrenngrabens 18 aufgebracht wurde. Diese Metallmaske kann z. B. Titan sein mit einer Dicke von etwa 400 nm. Anschließend erfolgt Trockenätzen mittels reaktiven Ionenstrahlätzens (RIBE) oder mittels eines mit III-V-Halbleitermaterial verträglichen Ionenätzprozesses (RIE) oder mittels eines mit III-V-Halbleitermaterial verträglichen ECR-RIE-Prozesses (electron cyclotron resonance reactive ion etching). Mit diesem Trockenätzprozeß wird der Kollektortrenngraben 18 bis auf die Tiefe der Kollektorschicht 5 ausgeätzt.

Anschließend wird der Kollektortrenngraben 18 mit einer Isolationsschicht 21 gefüllt (Fig. 8). Dafür kann z. B. Photonitrid Si₃N₄ oder SiO₂ verwendet werden. Die erste Maske 22 bleibt dabei stehen. Die Isolationsschicht 21 wird eventuell mittels einer weiteren Photolackschicht (z. B. AZ 111) zusätzlich eingeebnet. Anschließend wird die Isolationsschicht 21 ganzflächig zurückgeätzt z. B. mittels RIBE oder mittels eines mit dem Material der Isolationsschicht 21 verträglichen RIE- oder ECR-RIE-Prozeßschrittes. Der verbleibende Anteil der Isolationsschicht 21 füllt danach den Kollektortrenngraben 18 und planarisiert den Kollektortrenngraben 18. Die für den aktiven HBT-Komplex vorgesehenen Halbleiterschichten werden durch die verbliebene erste Maske 22 aus Metall geschützt (s. Fig. 9). Die erste Maske 22 wird danach naßchemisch entfernt (z. B. mit einer phosphorsäurehaltigen Ätze, wenn die erste Maske 22 aus Titan ist).

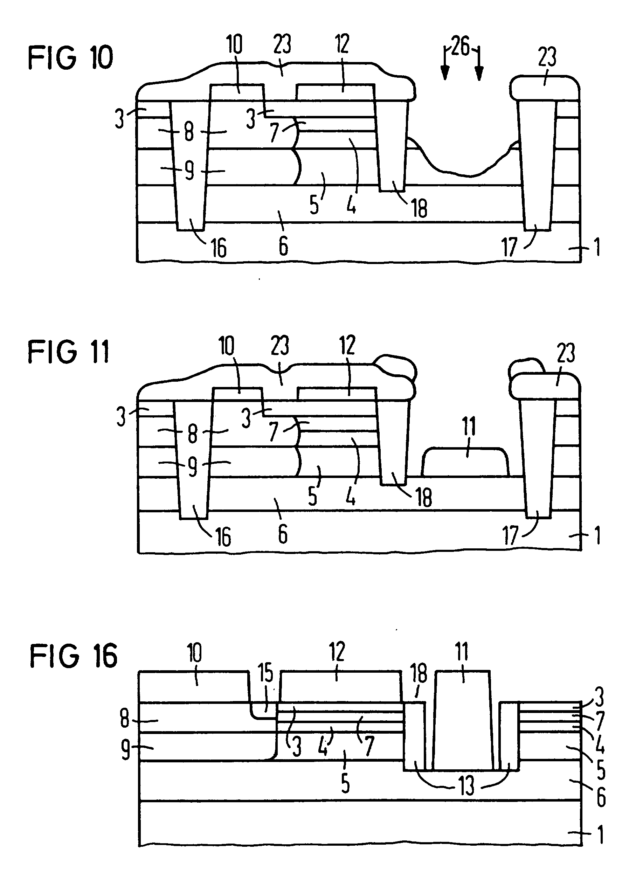

Von dem in Fig. 5 im Querschnitt dargestellten Aufbau ausgehend wird im folgenden in an sich bekannter Weise der Basis-Emitter-Komplex hergestellt. Fig. 10 zeigt den entsprechenden Aufbau mit fertigem Basis-Emitter-Komplex und einer aufgebrachten zweiten Maske 23 (z. B. Photolack) mit einer Öffnung im Bereich des herzustellenden Kollektoranschlusses. Dieser gesamte Bereich zwischen dem Kollektortrenngraben 18 und gegebenenfalls einem Isolationsgraben 17 wird ausgeätzt (26). Dabei wird die gesamte Schichtfolge einschließlich der Kollektorschicht 5 abgetragen, mindestens bis die Oberfläche der Subkollektorschicht 6 in diesem Bereich freigelegt ist. Dann wird entsprechend Fig. 11 die Kollektor-Metallisierung 11 aufgebracht und das restliche Metall auf der zweiten Maske 23 zusammen mit dieser zweiten Maske 23 in Abhebetechnik (lift off) entfernt. Anschließend können Isolationsimplantierungen 15 eingebracht werden und die Oberfläche mit einer Passivierung 13 planarisiert werden. Man erhält so den Aufbau entsprechend Fig. 1.

Der Aufbau des Basis-Emitter-Komplexes bei einem erfindungsgemäßen Heterobipolartransistor ist nicht festgelegt, sondern kann verschiedene bekannte Strukturen aufweisen. Statt einer planaren Ausführung kommt auch eine mesastrukturierte Ausführung in Frage. Wesentlich ist, daß bei dem erfindungsgemäßen Aufbau eine Planarisierung des Kollektors möglich ist. Besondere Vorteile des Heterobipolartransistors entsprechend vorliegender Erfindung sind insbesondere:
Der mit einem isolierenden Material gefüllte Kollektortrenngraben ersetzt die üblicherweise bei einem nichtselbstjustierten Basis-Kollektor- bzw. Emitter-Kollektor-Übergang vorhandene parasitäre Basis-Kollektor-Fläche zwischen Emitter und Kollektor bzw. zwischen Basis und Kollektor. Z. B. bedeutet das für einen Heterobipolartransistor mit selbstjustiertem Emitter-Basis-Komplex (SA E-B-HBT) mit 2 x 5 µm Emitter- und Basisfläche und einem Abstand von 2 µm vom Emitter zum Kollektoranschluß eine Verringerung der Basis-Kollektor-Fläche im Emitter-Basis-Komplex um 30 %. Setzt man ansonsten gleiche Parameter für den Heterobipolartransistor voraus, so erniedrigt sich infolge dieser Maßnahme die Kollektorladezeit t_{CC} um 30 %, die Emitterladezeit t_{E} entsprechend dem Verhältnis von Basis-Emitter- und Basis-Kollektor-Kapazität um knapp 30 %, d. h. die Transitfrequenz der Ladungsträger f_{T} = 1/ [2π (t_{E} + t_{B} + t_{C} + t_{CC})] wird wesentlich erhöht. (t_{B} und t_{C} bedeuten die Basis- bzw. Kollektorlaufzeit der Ladungsträger.) Die Grenzfrequenz der Stromverstärkung fₘₐₓ = [f_{T} (8π R_{B} C_{BC})] ^{1/2} erhöht sich, abgesehen von der impliziten Erhöhung von f_{T} um weitere 20 %. R_{B} bedeutet den Basisbahnwiderstand, C_{BC} die Basis- Kollektor-Kapazität.

Der Basis-Emitter-Komplex kann auch nach der Planarisierung des Kollektortrenngrabens in an sich bekannter Weise als selbstjustierter oder nichtselbstjustierter planarer oder mesastrukturierter Basis-Emitter-Komplex hergestellt werden. Wesentlich ist, daß im Falle eines asymmetrischen Heterobipolartransistors (s. Fig. 1) mit nur je einem Basis- und Emitteranschluß die Emitter-Metallisierung 12 in einer Phototechnik, die bezüglich des Kollektortrenngrabens 18 unkritisch ist, vorgenommen werden kann. Die auf der Seite des Kollektors befindliche Flanke der aufgebrachten Emitter-Metallisierung 12 schließt bei einer idealen Realisierung des erfindungsgemäßen HBT mit der auf der Seite des Emitters befindlichen oberen Kante des Kollektortrenngrabens ab. Es ist tolerierbar, wenn das Metall der Emitter-Metallisierung über die obere Kante des Kollektortrenngrabens um einige zehntel pm ragt. Entsprechendes gilt bei einem symmetrischen HBT mit zwei Basisanschlüssen für den kollektorseitigen Basisanschluß.

Ein weiterer Vorteil des Kollektortrenngrabens besteht in der freien Wahl der Strukturierung des Kollektoranschlusses über die Subkollektorschicht 6. Nach der Herstellung des Basis-Emitter-Komplexes kann folgendermaßen vorgegangen werden: Der Kollektorrecess wird mittels einer unkritischen Phototechnik definiert. Der Kollektorrecess wird mit einem gegenüber der passivierenden Isolationsschicht 21 im Kollektortrenngraben 18 selektiven naßchemischen Ätzverfahren (z. B. Ammoniakätze für das Materialsystem AlGaAs/GaAs) oder mit einem Trockenätzverfahren (z. B. RIBE oder RIE bzw. ECR-RIE für III-V-Halbleitermaterial) oder in einer Kombination aus trocken- und naßchemischen Ätzverfahren bis zur Subkollektorschicht 6 hin geätzt, dabei wird in dem Bereich des Kollektorrecesses die Oberfläche der Subkollektorschicht 6 freigelegt. Dabei bleibt wegen des aufgefüllten Kollektortrenngrabens die Heteroschichtfolge im inneren HBT (Basis-Emitter-Komplex) geschützt.

Vorteilhaft ist dabei, wenn die Kanten des Photolackes den Kollektortrenngraben überragen (z. B. einige zehntel µm bis etwa 0,5 bis 0,7 µm). Dadurch wird eine gezielte Unterätzung des Photolackes bis zur oberen Kante des Kollektortrenngrabens mittels eines zumindest teilweise isotropen Ätzprozesses erreicht. Diese Unterätzung unterstützt die nachfolgende Abhebetechnik (lift off) bei der nun folgenden Aufbringung der Kollektor-Metallisierung 11 für den Kollektoranschluß. Diese Kollektor-Metallisierung 11 kann in beliebiger Schichtdicke, z. B. bis zur Höhe der Basis-Metallisierung 10 und der Emitter-Metallisierung 12 aufgebracht und einlegiert werden.

Der gesamte HBT wird nun passiviert, was z. B. mit einer Ergänzung der Isolationsschicht 21 mit einer weiteren Si₃N₄- Schicht oder SiO₂-Schicht erfolgen kann. Damit wird die Isolationsschicht 21 so erweitert, daß die verbliebenen Zwischenräume zwischen dem Anteil der Isolationsschicht 21 in dem Kollektortrenngraben 18 und der Kollektor-Metallisierung 11 geschlossen werden. Auf die gleiche Weise, wie die Planarisierung des in den Kollektortrenngraben 18 eingebrachten Materiales vorgenommen wurde, wird die Isolationsschicht 21 (mit einebnendem Photolack darauf) auf die Höhe der Emitter-Metallisierung 12, der Basis-Metallisierung 10 und der Kollektor-Metallisierung 11 planar zurückgeätzt. Mit einer weiteren Phototechnik auf ebener Topologie kann mit einem Verbindungsmetall strukturgenau, problemlos und sicher die Schaltung mit einer Verbindungsmetallisierung 14 verdrahtet werden (s. Fig. 1).

Wenn eine Passivierung benötigt wird, die dicker ist als die Emitter-Metallisierung 12 und die Basis-Metallisierung 10, kann die Verbindungsmetallisierung 14 auch aufgebracht werden, indem durch diese dickere Passivierungsschicht Kontaktlöcher geätzt werden, durch die dann die Verbindungsmetallisierung 14 auf die Emitter-, Basis- und Kollektor-Metallisierungen 12, 10, 11 aufgebracht wird.

In Fig. 1 ist im Querschnitt ein planarer HBT dargestellt mit einem erfindungsgemäß ausgestalteten Kollektor mit dem Kollektortrenngraben 18 und einer Passivierung 13, die in Isolationsgräben 16, 17 bis zum nichtleitenden Substrat 1 für die Isolation des gesamten Heterobipolartransistors gegenüber lateral angrenzenden Funktionselementen reicht. Mit dieser zusätzlichen elektrischen Isolierung durch weitere Isolationsgräben ist es möglich, Schaltungen besonders kompakt zu entwerfen. Diese Isolationsgräben werden analog zum Kollektortrenngraben hergestellt. Die Isolation durch Einbringen von isolierendem Material (Passivierung 13) in dafür vorgesehene Isolationsgräben 16, 17 kann bei Verwendung von Maskentechnik in einem beliebigen Schritt in dem Herstellungsverfahren vorgenommen werden. Besonders vorteilhaft, weil das Herstellungsverfahren vereinfachend, ist das Einbringen der Passivierung 13 im Anschluß an das Aufbringen der Kollektor-Metallisierung 11. Es kann dann in einem Verfahrensschritt die Passivierung 13 aufgebracht werden und gleichzeitig damit die Isolationsgräben und die Zwischenräume im Kollektorbereich gefüllt werden.

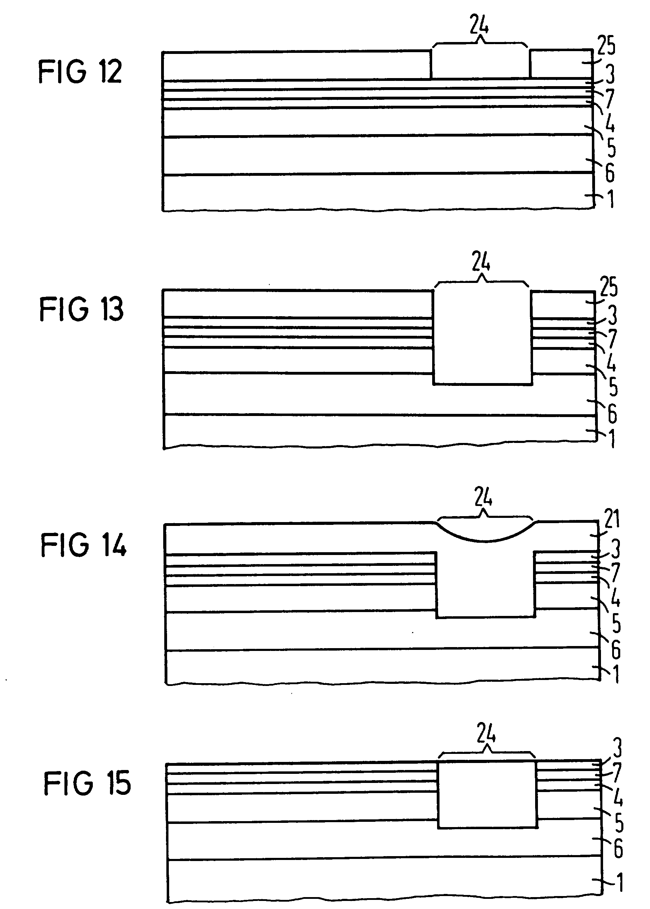

In den Fig. 12 bis 16 sind die Aufbauten im Querschnitt nach fünf verschiedenen Verfahrensschritten eines alternativen Herstellungsverfahrens dargestellt. Bei dieser Variante des Herstellungsverfahrens wird statt des Kollektortrenngrabens das gesamte Gebiet für den Kollektoranschluß mittels Maskentechnik freigelegt. Fig. 12 zeigt den Aufbau mit der Schichtfolge aus Subkollektorschicht 6, Kollektorschicht 5 und den weiteren Schichten (Basisschicht 4, Pufferschicht 7, Emitterschicht 3) auf dem Substrat 1 und mit einer auf die oberste Schicht aufgebrachten dritte Maske 25 aus Lack oder Metall mit einer Öffnung im Bereich 24, der für den Kollektoranschluß vorgesehen ist. Unter Anwendung eines der oben angegebenen Ätzverfahren wird in diesem Bereich 24 für den Kollektoranschluß das Halbleitermaterial der aufgewachsenen Schichten bis einschließlich der Kollektorschicht 5 abgeätzt, so daß in diesem Bereich 24 die Oberfläche der Subkollektorschicht 6 freigelegt ist, aber höchstens ein oberer Schichtanteil dieser Subkollektorschicht 6 mit abgetragen wird (Fig. 13). Anschließend wird dieser Kollektorrecess mit einer Isolationsschicht 21 aufgefüllt (Fig. 14) und planarisiert (Fig. 15). Dabei wird die Oberfläche des Halbleitermateriales außerhalb des Kollektorrecesses freigelegt.

Der Bereich für den Anschluß des Kollektors wird vor oder nach der Herstellung des Emitter-Basis-Komplexes festgelegt, wobei man sich einer für den Emitter-Basis-Komplex unkritischen Phototechnik innerhalb des bereits isolierten Kollektoranschlußgebietes bedient. In die Passivierung, die durch den in dem Kollektorrecess befindlichen Anteil der Isolations- schicht 21 gebildet wird, wird dann mit einer zumindest teilweise isotropen Ätzung (Unterätzung einer weiteren aufgebrachten Photolackmaske) eine Öffnung in diese Passivierung geätzt, so daß ein Anteil der Oberfläche der Subkollektorschicht 6 im Bereich 24 des vorgesehenen Kollektoranschlusses freigelegt ist. Danach wird entsprechend Fig. 16 die Kollektor-Metallisierung 11 bis zu der vorgesehenen Höhe (z. B. bis zur Höhe der Basis- und Emitter-Metallisierungen 10, 12) aufgebracht. Das geschieht z. B. mittels Abhebetechnik (lift off). Von der aufgebrachten Isolationsschicht 21 sind nurmehr Anteile als Passivierung 13 in dem Kollektorrecess zwischen dessen Wand und der Kollektor-Metallisierung 11 verblieben. Der Zwischenraum zwischen diesen verbliebenen Anteilen aus isolierendem Material und der Kollektor-Metallisierung 11 kann dann mit einer weiteren Passivierung aufgefüllt werden, mit der zusätzlich die Oberfläche planarisiert, d. h. die Zwischenräume zwischen Basis-Metallisierung 10, Emitter-Metallisierung 12 und Kollektor-Metallisierung 11 aufgefüllt werden können. Auch bei diesen alternativen Herstellungsverfahren ist man für die Ausgestaltung des Basis-Emitter-Komplexes nicht eingeschränkt.

Bei dem erfindungsgemäßen Heterobipolartransistor wird die Basis-Kollektor-Grenzfläche auf dem Basis-Emitter-Bereich des selbst- oder nichtselbstjustierten Emitter-Basis-Komplexes begrenzt. Der erfindungsgemäße Aufbau ermöglicht eine freie Handhabe bei der Ätzung des Kollektorrecesses (trocken- und/oder naßchemisch), wobei sich diese Ätzung nicht mehr auf die Eigenschaften des inneren Teiles des HBT, d. h. den Basis-Emitter-Komplex, auswirkt. Beim Aufbringen der Kollektor-Metallisierung besteht daher ebenfalls eine freie Wahl in der Schichtdicke dieser Metallisierung. Hohe Schichtdicken der Metallisierung, wie sie für einen planaren HBT nötig sind, führen dabei zu keinen Kurzschlüssen zwischen Emitter und Kollektor bzw. zwischen Basis und Kollektor.

## Patentansprüche

1. Verfahren zur Herstellung eines Heterobipolartransistors bei dem
in einem ersten Schritt auf ein Substrat (1) eine Subkollektorschicht (6), eine Kollektorschicht (5) und eine Schichtfolge mit mindestens einer Basisschicht (4) und einer Emitterschicht (3) aufgewachsen werden,
in einem zweiten Schritt eine erste Maske (20, 22) mit einer Öffnung im Bereich eines herzustellenden Kollektortrenngrabens (18) aufgebracht wird,
in einem dritten Schritt unter Verwendung dieser ersten Maske (20, 22) von der Oberfläche der obersten aufgewachsenen Halbleiterschicht (3) mindestens bis in die Kollektorschicht (5) und höchstens bis in einen oberen Schichtanteil der Subkollektorschicht (6) hinab ausgeätzt wird, wobei der Kollektortrenngraben (18) hergestellt wird,
in einem vierten Schritt der Kollektortrenngraben (18) mit einer Isolationsschicht (21) aus isolierendem Material aufgefüllt wird,
in einem fünften Schritt die Oberfläche der obersten aufgewachsenen Halbleiterschicht (3) freigelegt wird,
in einem sechsten Schritt ein Basis-Emitter-Komplex hergestellt und mit der Basis-Metallisierung (10) und mit der Emitter-Metallisierung (12) versehen wird,
in einem siebenten Schritt eine zweite Maske (23) mit einer Öffnung im Bereich eines herzustellenden Kollektoranschlusses aufgebracht wird,
in einem achten Schritt unter Verwendung dieser zweiten Maske (23) von der Oberfläche der obersten aufgewachsenen Halbleiterschicht (3) bis zur Subkollektorschicht (6) hinab ausgeätzt (26) wird und
in einem neunten Schritt die Kollektor-Metallisierung (11) aufgebracht und die zweite Maske (23) in Abhebetechnik entfernt wird.

2. Verfahren nach Anspruch 1, bei dem
in einem zehnten Schritt eine Isolationsimplantierung (15) in Bereiche an den freiliegenden Oberflächen des Halbleitermaterials eingebracht wird und
in einem elften Schritt die Oberfläche des Heterobipolartransistors mit einer Passivierung (13) aus einem isolierenden Material planarisiert und Verbindungsmetallisierungen (14) auf die Basis-Metallisierung (10), die Kollektor-Metallisierung(11) und die Emitter-Metallisierung (12) aufgebracht werden.

3. Verfahren nach Anspruch 1 oder 2, bei dem
in dem zweiten Schritt mittels Maskentechnik zusätzlich mindestens ein Isolationsgraben (16, 17) hergestellt wird welcher von der Oberfläche der obersten aufgewachsenen Halbleiterschicht (3) mindestens bis in das Substrat (1) hineinreichend ausgebildet wird, wobei dieser Isolationsgraben (16, 17) eine laterale elektrische Isolation des Heterobipolartransistors nach außen hin bewirkt.

4. Verfahren nach Anspruch 3, bei dem
im zweiten Schritt zunächst eine Lackmaske (19) aufgebracht wird und unter Verwendung dieser Lackmaske (19) der mindestens eine Isolationsgraben (16, 17) hergestellt wird,
dann diese Lackmaske (19) entfernt und die erste Maske (20) aufgebracht wird.

5. Verfahren nach Anspruch 4, bei dem
vor dem Aufbringen der ersten Maske (22) jeder Isolationsgraben (16, 17) mit isolierendem Material aufgefüllt wird.

6. Verfahren nach einem der Ansprüche 1 bis 5, bei dem
die im zweiten Schritt aufgebrachte erste Maske (20) Photolack ist und
diese erste Maske vor dem vierten Schritt entfernt wird.

7. Verfahren nach einem der Ansprüche 1 bis 5, bei dem
die im zweiten Schritt aufgebrachte erste Maske (22) Metall ist und
diese erste Maske (22) im fünften Schritt entfernt wird.

8. Verfahren zur Herstellung eines Heterobipolartransistors bei dem
in einem ersten Schritt auf ein Substrat (1) eine Subkollektorschicht (6) und eine Schichtfolge aus einer Kollektorschicht (5), einer Basisschicht (4), einer Pufferschicht (7) und einer Emitterschicht (3) aufgewachsen wird,
in einem zweiten Schritt eine erste Maske (25) mit einer Öffnung im Bereich des herzustellenden Kollektors aufgebracht wird,
in einem dritten Schritt unter Verwendung dieser ersten Maske (25) von der Oberfläche der obersten aufgewachsenen Halbleiterschicht (3) bis zur Subkollektorschicht (6) hinab ausgeätzt wird, wobei ein für den Kollektoranschluß vorgesehener Bereich (24) hergestellt wird,
in einem vierten Schritt die erste Maske (25) entfernt wird, in einem fünften Schritt der für Kollektoranschluß vorgesehene Bereich (24) mit einer Isolationsschicht (21) aufgefüllt wird,
in einem sechsten Schritt die Oberfläche der obersten aufgewachsenen Halbleiterschicht (3) freigelegt wird,
in einem siebenten Schritt ein Basis-Emitter-Komplex hergestellt und mit der Basis-Metallisierung (10) und mit der Emitter-Metallisierung (12) versehen wird,
in einem achten Schritt der verbliebene Anteil der Isolationsschicht (21) bis zur Subkollektorschicht (6) hinab ausgeätzt wird, wobei am Rand jeweils ein Anteil als Passivierung (13) stehenbleibt, und
in einem neunten Schritt die freigelegte Oberfläche der Subkollektorschicht (6) mit der Kollektor-Metallisierung (11) versehen wird.

9. Verfahren nach Anspruch 8, bei dem
in einem zehnten Schritt eine Isolationsimplantierung (15) in Bereiche an den freiliegenden Oberflächen des Halbleitermateriales eingebracht wird und
in einem elften Schritt die Oberfläche des Heterobipolartransistors mit einer Passivierung aus einem isolierenden Material planarisiert und Verbindungsmetallisierungen auf die Basis-Metallisierung (10), die Kollektor-Metallisierung (11) und die Emitter-Metallisierung (12) aufgebracht werden.

10. Verfahren nach Anspruch 8 oder 9, bei dem in dem
zweiten Schritt mittels Maskentechnik zusätzlich mindestens ein Isolationsgraben (16, 17) hergestellt wird, welcher von der Oberfläche der obersten aufgewachsenen Halbleiterschicht (3) mindestens bis in das Substrat (1) hinreichend ausgebildet wird, wobei
dieser Isolationsgraben (16, 17) eine laterale elektrische Isolation des Heterobipolartransistors nach außen hin bewirkt.

11. Verfahren nach Anspruch 10, bei dem
im zweiten Schritt zunächst eine Lackmaske aufgebracht wird und unter Verwendung dieser Lackmaske der mindestens eine Isolationsgraben hergestellt wird,
dann diese Lackmaske entfernt und die erste Maske (25) aufgebracht wird.

12. Verfahren nach Anspruch 11, bei dem
vor dem Aufbringen der ersten Maske (25) jeder Isolationsgraben mit isolierendem Material aufgefüllt wird.

## Claims

1. Method for producing a heterojunction bipolar transistor in which
in a first step a sub-collector layer (6), a collector layer (5) and a layer sequence which includes at least a base layer (4) and an emitter layer (3) are grown onto a substrate (1),
in a second step a first mask (20, 22) is applied with an opening in the region of a collector isolating trench (18) to be produced,
in a third step, using this first mask (20, 22), an etching-out operation is performed from the surface of the top grown-on semiconductor layer (3) at least down into the collector layer (5) and at most down into an upper layer portion of the sub-collector layer (6), the collector isolating trench (18) being produced,
in a fourth step the collector isolating trench (18) is filled with an insulation layer (21) made of insulating material,
in a fifth step the surface of the top grown-on semiconductor layer (3) is exposed,
in a sixth step a base-emitter complex is produced and is provided with the base metallization layer (10) and with the emitter metallization layer (12),
in a seventh step a second mask (23) is applied with an opening in the region of a collector terminal to be produced,
in an eighth step, using this second mask (23), an etching-out operation (26) is performed from the surface of the top grown-on semiconductor layer (3) down to the sub-collector layer (6), and
in a ninth step the collector metallization layer (11) is applied and the second mask (23) is removed using a lift- off technique.

2. Method according to Claim 1, in which
in a tenth step insulation is implanted (15) into regions on the exposed surfaces of the semiconductor material, and
in an eleventh step the surface of the heterojunction bipolar transistor is planarized with a passivation layer (13) made of an insulating material, and connecting metallization layers (14) are applied to the base metallization layer (10), the collector metallization layer (11) and the emitter metallization layer (12).

3. Method according to Claim 1 or 2, in which
in the second step at least one insulation trench (16, 17) is additionally produced, by means of a mask technique, which trench is formed to reach from the surface of the top grown-on semiconductor layer (3) at least down into the substrate (1), this insulation trench (16, 17) effecting lateral electrical insulation of the heterojunction bipolar transistor with respect to the outside.

4. Method according to Claim 3, in which
in the second step a resist mask (19) is initially applied and, using this resist mask (19), the at least one insulation trench (16, 17) is produced, then this resist mask (19) is removed and the first mask (20) is applied.

5. Method according to Claim 4, in which
each insulation trench (16, 17) is filled with insulating material before the first mask (22) is applied.

6. Method according to one of Claims 1 to 5, in which
the first mask (20) applied in the second step is photoresist, and
this first mask is removed before the fourth step.

7. Method according to one of Claims 1 to 5, in which
the first mask (22) applied in the second step is metal, and
this first mask (22) is removed in the fifth step.

8. Method for producing a heterojunction bipolar transistor in which
in a first step a sub-collector layer (6) and a layer sequence comprising a collector layer (5), a base layer (4), a buffer layer (7) and an emitter layer (3) are grown onto a substrate (1),
in a second step a first mask (25) is applied with an opening in the region of the collector to be produced,
in a third step, using this first mask (25), an etching-out operation is performed from the surface of the top grown-on semiconductor layer (3) down to the sub-collector layer (6), a region (24) envisaged for the collector terminal being produced,
in a fourth step the first mask (25) is removed,
in a fifth step the region (24) envisaged for the collector terminal is filled with an insulation layer (21), in a sixth step the surface of the top grown-on semiconductor layer (3) is exposed,
in a seventh step a base-emitter complex is produced and is provided with the base metallization layer (10) and with the emitter metallization layer (12),
in an eighth step the remaining portion of the insulation layer (21) is etched out down to the sub-collector layer (6), a portion remaining at the edge in each case as a passivation layer (13), and
in a ninth step the exposed surface of the sub-collector layer (6) is provided with the collector metallization layer (11) .

9. Method according to Claim 8, in which
in a tenth step insulation is implanted (15) into regions on the exposed surfaces of the semiconductor material, and
in an eleventh step the surface of the heterojunction bipolar transistor is planarized with a passivation layer made of an insulating material, and connecting metallization layers are applied to the base metallization layer (10), the collector metallization layer (11) and the emitter metallization layer (12).

10. Method according to Claim 8 or 9, in which
in the second step at least one insulation trench (16, 17) is additionally produced, by means of a mask technique, which trench is formed to reach from the surface of the top grown-on semiconductor layer (3) at least down into the substrate (1), this insulation trench (16, 17) effecting lateral electrical insulation of the heterojunction bipolar transistor with respect to the outside.

11. Method according to Claim 10, in which
in the second step a resist mask is initially applied and, using this resist mask, the at least one insulation trench is produced,
then this resist mask is removed and the first mask (25) is applied.

12. Method according to Claim 11, in which
each insulation trench is filled with insulating material before the first mask (25) is applied.

## Revendications

1. Procédé de fabrication d'un transistor bipolaire à hétérojonction, dans lequel
au cours d'une première étape, on dépose sur un substrat (1) une couche de sous-collecteur (6). une couche de collecteur (5) et une suite de couches avec au moins une couche de base (4) et une couche d'émetteur (3),
au cours d'une deuxième étape on applique un premier masque (20, 22) avec une ouverture dans la région de la tranchée de séparation de collecteur (18) à fabriquer,
au cours d'une troisième étape, on décape, en utilisant ce premier masque (20, 22) de la surface de la couche supérieure de semi-conducteur déposée (3) au moins jusque dans la couche de collecteur (5) et au maximum jusque dans une partie de couche supérieure de la couche de sous-collecteur (6), étape par laquelle on réalise la tranchée de séparation de collecteur (18),
au cours d'une quatrième étapes la tranchée de séparation de collecteur (18) est remplie avec une couche d'isolation (21) en matériau isolant,
au cours d'une cinquième étape, la surface de la couche supérieure de matériau semi-conducteur déposée (3) est dégagée,
au cours d'une sixième étape, un complexe de base-émetteur est préparé et muni d'une métallisation de base (10) et d'une métallisation d'émetteur (12),
au cours d'une septième étape, un deuxième masque (23) avec une ouverture est déposé dans la région de la connexion de collecteur à réaliser,
au cours d'une huitième étape, on décape (26), en utilisant ce deuxième masque (23), de la surface de la couche supérieure de semi-conducteur déposée (3) jusqu'à la couche de sous-collecteur (6) et
au cours d'une neuvième étape, la métallisation de collecteur (11) est appliquée et le deuxième masque (23) est enlevé par la technique de décollage.

2. Procédé selon la revendication 1, dans lequel
au cours d'une dixième étape, une implantation d'isolation (15) est introduite dans des régions adjacentes aux surfaces dégagées du matériau semi-conducteur et au cours d'une onzième étape, la surface du transistor bipolaire à hétérojonction est planifiée avec une passivation (13) constituée d'un matériau isolant et des métallisations de liaison (14) sont appliquées sur la métallisation de base (10), sur la métallisation de collecteur (11) et sur la métallisation d'émetteur (12).

3. Procédé selon la revendication 1 ou 2, dans lequel
au cours de la deuxième étape, on réalise au moyen de la technique de masquage en outre au moins une tranchée d'isolation (16, 17). qui est développée de la surface de la couche supérieure de semi-conducteur déposée (3) au moins jusque dans le substrat (1), cette tranchée d'isolation (16, 17) entraînant une isolation électrique latérale du transistor bipolaire à hétérojonction vers l'extérieur.

4. Procédé selon la revendication 3, dans lequel
au cours de la deuxième étape, on applique d'abord un masque de laque (19) et on réalise en utilisant ce masque de laque (19) au moins une tranchée d'isolation (16, 17), on enlève ensuite ce masque de laque (19) et on applique le premier masque (20).

5. Procédé selon la revendication 4, dans lequel
on remplit avant l'application du premier masque (22) toute tranchée d'isolation (16, 17) avec du matériau isolant.

6. Procédé selon l'une quelconque des revendications 1 à 5, dans lequel
le premier masque (20) appliqué au cours de la deuxième étape est constitué de laque photosensible et
ce premier masque est enlevé avant la quatrième étape.

7. Procédé selon l'une quelconque des revendications 1 à 5, dans lequel
le premier masque (22) appliqué au cours de la deuxième étape est en métal et ce premier masque (22) est enlevé au cours de la cinquième étape.

8. Procédé de fabrication d'un transistor bipolaire à hétérojonction, dans lequel
au cours d'une première étape, on dépose sur un substrat (1) une couche de sous-collecteur (6) et une suite de couches constituée d'une couche de collecteur (5), d'une couche de base (4), d'une couche tampon (7) et d'une couche d'émetteur (3),
au cours d'une deuxième étape, on applique un premier masque (25) avec une ouverture dans la région du collecteur (18) à fabriquer,
au cours d'une troisième étape, on décape, en utilisant ce premier masque (25) de la surface de la couche supérieure de semi-conducteur déposée (3) jusqu'à la couche de sous-collecteur (6), étape par laquelle on réalise une région (24) prévue pour la connexion du collecteur,
au cours d'une quatrième étape, le premier masque (25) est enlevé,
au cours d'une cinquième étape, la région (24) prévue pour la connexion du collecteur est remplie avec une couche d'isolation (21),
au cours d'une sixième étape, la surface de la couche supérieure de semi-conducteur déposée (3) est dégagée,
au cours d'une septième étape, un complexe de base-émetteur est produit et muni d'une métallisation de base (10) et d'une métallisation d'émetteur (12).
au cours d'une huitième étape, on décape la partie restante de la couche d'isolation (21) jusqu'à la couche de sous-collecteur (6), une partie étant conservée au bord à titre de passivation (13), et
au cours d'une neuvième étape, la surface dégagée de la couche de sous-collecteur (6) est munie de la métallisation de collecteur (11).

9. Procédé selon la revendication 8, dans lequel
au cours d'une dixième étape, une implantation d'isolation (15) est introduite dans des régions adjacentes aux surfaces dégagées du matériau semi-conducteur et
au cours d'une onzième étape, la surface du transistor bipolaire à hétérojonction est planifiée avec une passivation constituée d'un matériau isolant et des métallisations de liaison sont appliquées sur la métallisation de base (10), sur la métallisation de collecteur (11) et sur la métallisation d'émetteur (12).

10. Procédé selon la revendication 8 ou 9, dans lequel
au cours de la deuxième étape, on réalise au moyen de la technique de masquage en outre au moins une tranchée d'isolation (16, 17), qui est développée de la surface de la couche supérieure de semi-conducteur déposée (3) au moins jusque dans le substrat (1), cette tranchée d'isolation (16, 17) entraînant une isolation électrique latérale du transistor bipolaire à hétérojonction vers l'extérieur.

11. Procédé selon la revendication 10, dans lequel
au cours de la deuxième étape, on applique d'abord un masque de laque et on réalise en utilisant ce masque de laque au moins une tranchée d'isolation, on enlève ensuite ce masque de laque et on applique le premier masque (25).

12. Procédé selon la revendication 11, dans lequel
on remplit avant l'application du premier masque (25) toute tranchée d'isolation avec du matériau isolant.
